# EUROPÄISCHE PATENTSCHRIFT

(11) **EP 1 208 586 B1**
(45) Veröffentlichungstag und Bekanntmachung des Hinweises auf die Patenterteilung: **12.09.2007**
(21) Anmeldenummer: 00954498.2
(22) Anmeldetag: 14.07.2000
(51) Int. Cl.: H01L 21/00

(54) **VORRICHTUNG ZUM BEHANDELN VON SUBSTRATEN**
DEVICE FOR TREATING SUBSTRATES
DISPOSITIF POUR TRAITER DES SUBSTRATS

(30) Priorität: 21.07.1999 DE 19934300
(43) Veröffentlichungstag der Anmeldung: 29.05.2002
(73) Patentinhaber: IMEC, 3001 Heverlee-Leuven (BE)
(72) Erfinder: SPEH, Ulrich, D-71144 Steinenbronn (DE); SCHNEIDER, Jens, D-72766 Reutlingen (DE); MEURIS, Marc, B-3001 Leuven (BE)
(74) Vertreter: pronovem
(86) Internationale Anmeldenummer: PCT/EP2000/006716
(87) Internationale Veröffentlichungsnummer: WO 2001/008200

(56) Entgegenhaltungen:
- US-A- 5 203 798
- US-A- 5 503 171
- PATENT ABSTRACTS OF JAPAN vol. 018, no. 199 (E-1534), 7. April 1994 (1994-04-07) -& JP 06 005577 A (NEC CORP), 14. Januar 1994 (1994-01-14)
- PATENT ABSTRACTS OF JAPAN vol. 015, no. 143 (E-1054), 11. April 1991 (1991-04-11) -& JP 03 020031 A (MATSUSHITA ELECTRON CORP), 29. Januar 1991 (1991-01-29)

## Beschreibung

Die vorliegende Erfindung bezieht sich auf eine Vorrichtung zum Behandeln von Substraten, mit wenigstens einem in einer Gasatmosphäre angeordneten, ein Behandlungsfluid enthaltenden Prozeßbehälter, der wenigstens zwei unterhalb einer Behandlungsfluidoberfläche liegende, ständig geöffnete Öffnungen zum linearen Durchführen der Substrate aufweist.

Eine derartige Vorrichtung, die beispielsweise aus der EP-A-0 817 246 bekannt ist, ist ein statisches System, bei dem das Behandlungsfluid in dem Prozeßbehälter steht, ohne sich zu bewegen. Dies führt dazu, daß der in dem Behälter auftretende Prozeß durch Verunreinigung des Behandlungsfluids insbesondere im Bereich der linearen Durchführung der Substrate beeinträchtigt wird. Eine gute und homogene Behandlung der Substrate ist somit nicht möglich.

Ferner ist aus der JP-A- 5-291 223 eine Vorrichtung zum Behandeln von Substraten bekannt, bei der ein von oben mit Behandlungsfluid befüllbarer Prozessbehälter zwei seitliche. Öffnungen aufweist. Die Öffnungen sind jeweils durch Schließelemente verschließbar, um während der Behandlung ein Austreten von Behandlungsfluid zu vermeiden. Auf dem Boden des Prozessbehälters ist ein Auslass für das Behandlungsfluid vorgesehen.

Aus den Patent Abstracts of Japan Band 18, Nr. 199 (E-1534) vom 7. April 1994 sowie der JP 06 005 577 ist eine Substratreinigungsvorrichtung gemäß dem Oberbegriff des Anspruchs 1 bekannt, bei der Substrate linear durch einen mit Behandlungsfluid gefüllten Behandlungsbehälter hindurchgeführt werden. Der Behandlungsbehälter weist zwei unterhalb der Behandlungsfluidoberfläche liegende Durchführöffnungen auf, die während der Behandlung der Substrate durch entsprechende Schließelemente verschlossen sind, um ein Austreten des Behandlungsfluids zu verhindern. Während des Einführens bzw. des Ausführens der Substrate in das Becken bzw. aus diesem heraus werden die Schließelemente geöffnet, um die Substrate hindurchzulassen.

Aus den Patent Abstracts of Japan Band 15, Nr. 143 (E-1045) vom 11. April 1991 sowie der JP-A-03 020 031 ist ferner eine Ultraschallreinigungsvorrichtung mit einem mit Behandlungsfluid gefüllten Behandlungsbehälter bekannt. Der Behandlungsbehälter weist einen höhenverstellbaren Überlaufschieber auf, der die Höhe des Fluidniveaus einstellt, und darüber das Verhalten der Ultraschallwelle in dem Behandlungsfluid beeinflußt.

Ausgehend von dem oben genannten Stand der Technik liegt der vorliegenden Erfindung daher die Aufgabe zugrunde, eine Vorrichtung der Eingangs genannten Art vorzusehen, die auf einfache und kostengünstige Weise eine homogenere und verbesserte Behandlung von Substraten ermöglicht.

Erfindungsgemäß wird die Aufgabe bei einer Vorrichtung gemäß Anspruch 1. Durch den Überlauf für das Behandlungsfluid wird ein ständiges Hindurchleiten von Behandlungsfluid durch den Prozeßbehälter ermöglicht. Hierdurch werden erhöhte Verunreinigungskonzentrationen in bestimmten Bereichen des Prozeßbehälters, insbesondere im linearen Durchführbereich der Substrate verhindert bzw. Konzentrationsänderungen der Reinigungsmedien (Verbrauch während der Reinigung) wieder ausgeglichen. Hierdurch wird eine verbesserte und homogenere Behandlung der Substrate gewährleistet. Ferner wird durch einen Überlauf auf einfache und kostengünstige Weise ein im wesentlichem gleichmäßiges Behandlungsfluidniveau während der Behandlung und somit ein gleichmäßiger Druck des Behandlungsfluids an den Öffnungen sichergestellt. Trotz einer Strömung des Behandlungsfluids kann durch den gleichmäßigen Druck auf einfache Weise verhindert werden, daß das Behandlungsfluid aus dem Prozeßbehälter fließt. Durch die geschlossene Prozeß-/Überlaufbehälter-Kombination wird das Anlegen eines Vakuums in einem gemeinsamen oberhalb der Behandlungsfluidoberfläche gebildeten Luftraum ermöglicht. Über das Vakuum kann ein Unterdruck an den unterhalb der Behandlungsfluidoberfläche liegenden Öffnungen erzeugt werden, um ein Herausfließen des Behandlungsfluids zu verhindern. In dem oberhalb des Behandlungsfluids befindlichen Luftraum wird vorzugsweise ein gleichmäßiges Vakuum vorgesehen. Die sich beispielsweise durch unterschiedliche Behandlungsfluids (aufgrund unterschiedlicher Dichten) ergebenden Druckveränderungen an den Öffnungen werden können durch verändern des Vakuums reguliert werden.

Bei einer besonders bevorzugten Ausführungsform der Erfindung ist der Überlauf höhenverstellbar, um das Behandlungsfluidniveau innerhalb des Prozeßbehälters zu verändern. Dies ist insbesondere vorteilhaft, wenn innerhalb des Prozeßbehälters Behandlungen mit verschiedenen Behandlungsfluids durchgeführt werden, welche unterschiedliche Dichten aufweisen, und sich - bei gleichem Fluidniveau - an den unter der Behandlungsfluidoberfläche liegenden Öffnungen unterschiedliche Druckverhältnisse ergeben würden. Diese können über den höhenverstellbaren Überlauf eingestellt werden, um ein Herausfließen des Behandlungsfluids durch die Öffnungen zu verhindern.

Für eine gleichmäßige und homogene Strömung innerhalb des Prozeßbehälters ist das Behandlungsfluid vorzugsweise über eine im wesentlichen horizontal angeordnete Diffusorplatte in den Prozeßbehälter einleitbar. Bei einer weiteren Ausführungsform der Erfindung ist unterhalb wenigstens einer der Öffnungen ein Auffangrinne am Außenumfang des Prozeßbehälters angebracht, um zu verhindern, daß gegebenenfalls aus dem Prozeßbehälter austretendes Behandlungsfluid die Umgebung des Prozeßbehälters verunreinigt.

Bei einer bevorzugten Ausführungsform der Erfindung ist wenigstens eine Ultraschalleinrichtung innerhalb des Prozeßbehälters vorgesehen, um durch die Beschallung der Substrate deren Behandlung, und zwar insbesondere Reinigungsvorgänge zu fördern. Dabei erstreckt sich die Ultraschalleinrichtung vorzugsweise über die gesamte Breite des Prozeßbehälters, und zwar senkrecht zur Bewegungsrichtung der Substrate sowie schwenkbar, um eine gleichmäßige Beschallung der Substrate über deren gesamte Oberfläche hinweg vorzusehen. Um eine gleichmäßige und homogene Strömung des Behandlungsfluids innerhalb des Prozeßbehälters zu ermöglichen, weist die Ultraschalleinrichtung vorzugsweise eine strömungsdynamische Form auf, d.h. daß sie in Strömungsrichtung einen geringen Strömungswiderstand aufweist. Für eine gute und gleichmäßige Behandlung beider Oberflächen des Substrats ist es vorzugsweise zwischen wenigstens zwei Ultraschalleinrichtungen hindurch bewegbar.

Bei einer weiteren Ausführungsform der Erfindung ist eine Ausgangsöffnung des Prozeßbehälters umgebende Trocknungskammer mit einer Einrichtung zum Einleiten eines die Oberflächenspannung des Behandlungsfluids verringernden Fluids vorgesehen. Durch das Vorsehen der Trocknungskammer an der Ausgangsöffnung können die zuvor behandelten Substrate direkt bei der Entnahme aus dem Prozeßbehälter mittels des Marangonieffekts getrocknet werden. Die Kammer bildet vorzugsweise ein im wesentlichen geschlossenes System, wodurch eine gleichmäßige N₂/IPA Atmosphäre am Waferaustritt gewährleistet wird.

Gemäß einer weiteren, bevorzugten Ausführungsform der Erfindung sind mehrere hintereinander angeordnete Prozeßbehälter vorgesehen. Diese ermöglichen, daß die Substrate ohne eine notwendige Veränderung ihrer Ausrichtung mehrere, gegebenenfalls unterschiedliche Prozeßschritte durchlaufen. Dabei beinhalten die Prozeßbehälter vorzugsweise unterschiedliche Behandlungsfluids, um unterschiedlichen Prozeßschritte vorzusehen. Zwischen den Prozeßbehältern ist vorzugsweise eine Befeuchtungseinrichtung vorgesehen, um zu verhindern, daß die Substrate zwischen den aufeinander folgenden Prozeßschritten antrocken, was nachfolgende Prozeßschritte beeinträchtigen könnten. Vorzugsweise ist die Befeuchtungseinrichtung derart ausgestaltet, daß die Substrate grob gespült werden, wodurch verhindert wird, daß Behandlungsfluid von einem Prozeßbehälter zum nächsten gelangt.

Die Erfindung wird nachfolgend anhand bevorzugter Ausführungsbeispiele unter Bezugnahme auf die Figuren, näher erläutert. Es zeigen:
- Figur 1: eine schematische Schnittansicht eines Ausführungsbeispieles der erfindungsgemäßen Behandlungsvorrichtung;
- Figur 2: eine vergrößerte Detailansicht einer Auffangrinne mit Tropfenfänger der Behandlungsvorrichtung.

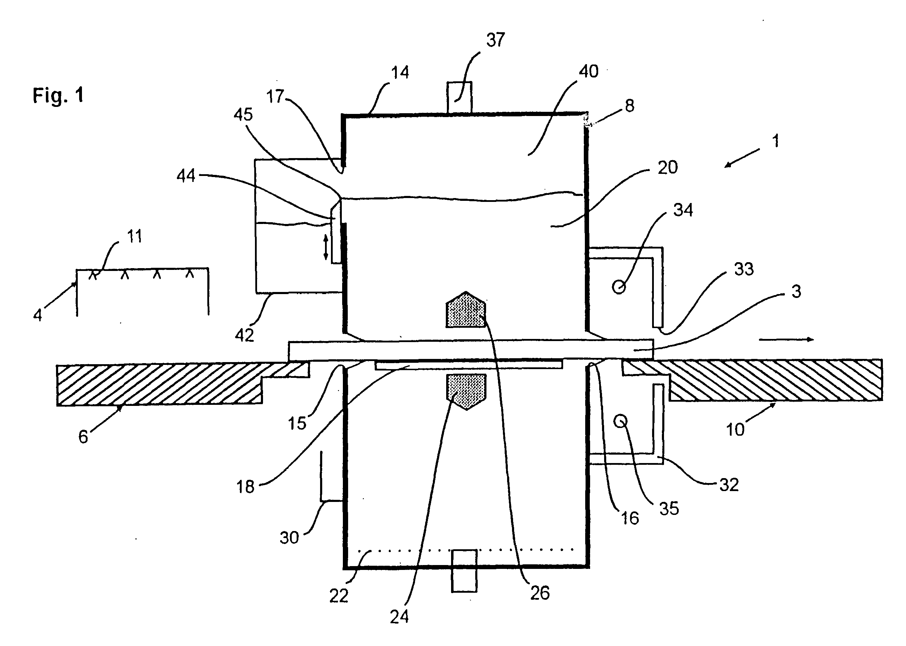

Figur 1 zeigt eine Behandlungsvorrichtung 1 für einen Halbleiterwafer 3, mit einer Befeuchtungseinrichtung 4, einer Wafer-Transporteinheit 6, einem Prozeßbehälter 8 und einer Wafertransporteinheit 10. Während einer Behandlung des Substrats 3 wird es gemäß der Figur von links durch die Wafertransporteinheit 6 an der Befeuchtungseinrichtung 4 vorbeibewegt und anschießend in den Prozeßbehälter 8 eingeführt, und teilweise durch diesen hindurch geschoben. Auf der anderen Seite wird der Wafer 3 durch die Wafertransporteinheit 10 aufgenommen und aus dem Prozeßbehälter 8 herausgezogen.

Die Befeuchtungseinrichtung 4 besitzt eine Vielzahl von Düsen 11, über die ein Fluid wie beispielsweise Dl-Wasser auf wenigstens eine Oberfläche des Wafers 3 gesprüht wird, um sie zu befeuchten, oder falls sie schon feucht ist, feucht zu halten. Obwohl dies in der Figur nicht dargestellt ist, können die Düsen 11 entgegen der Bewegungsrichtung des Wafers 3 gerichtet sein, um eine Spülung, wenigstens einer Oberfläche des Wafers 3 zu erreichen. Neben der dargestellten Befeuchtungseinrichtung 4, unter der der Wafer 3 hindurchbewegt wird, ist es auch möglich, eine zweite, der Befeuchtungseinrichtung 4 gegenüberliegende Befeuchtungseinrichtung vorzusehen, so daß der Wafer 3 durch beide Befeuchtungseinrichtungen hindurch bewegt wird, und somit von beiden Seiten befeuchtet wird.

Der Prozeßbehälter 8 wird durch einen geschlossenen Behälterkörper 14 gebildet, der eine Einführöffnung 15, eine Ausführöffnung 16 sowie eine Überlauföffnung 17 aufweist. Die Einführöffnung 15 und die Ausführöffnung 16 sind auf einer Ebene an sich gegenüberliegenden Seitenwänden des Behälterkörpers 14 ausgebildet. Weitere, nicht die Öffnungen 15, 16 aufweisende Seitenwände des Behälterkörpers 14 weisen Führungsschienen 18 zur Führung der Wafer 3 innerhalb des Prozeßbehälters 8 auf.

Die Öffnungen 15, 16 liegen unterhalb der Überlauföffnung 17 und liegen somit unterhalb einer Behandlungsfluidoberfläche eines in dem Prozeßbehälter 8 befindlichen Behandlungsfluids 20. Die Öffnungen 15, 16 können besonders ausgeformt sein, wie beispielsweise in der EP-A-0 817 246 beschrieben ist, um ein Ausfließen des in dem Prozeßbehälter 8 befindlichen Behandlungsfluids 20 zu unterbinden.

Im Bereich des Bodens des Prozeßbehälters 8 ist eine sich im wesentlichen horizontal erstreckende Diffusorplatte 22 vorgesehen, über die von unten das Behandlungsfluid 20 in dem Prozeßbehälter 8 eingeleitet wird. Durch die Diffusorplatte 22 wird eine gleichmäßige, nach oben gerichtete Strömung des Behandlungsfluids 20 innerhalb des Prozeßbehälters 8 erzeugt. Innerhalb des Prozeßbehälters sind zwei, sich über die gesamte Breite (gemäß der Figur senkrecht zur Zeichnungsebene) erstreckende Ultraschall- bzw. Megasoniceinrichtungen 24, 26 vorgesehen. Die Ultraschalleinrichtungen 24, 26 weisen zueinander und sind höhenmäßig unterhalb bzw. oberhalb der Öffnungen 15, 16 angeordnet, so daß die Wafer 3 bei ihrer Bewegung durch den Prozeßbehälter durch die Ultraschalleinrichtungen 24, 26 hindurch bewegt werden. Die voneinander wegweisenden Seiten der Ultraschalleinrichtungen 24, 26 sind jeweils abgeschrägt, um die von unten nach oben in dem Prozeßbehälter 8 gerichtete Fluidströmung so wenig wie möglich zu beeinträchtigen.

Im Bereich der Eingangsöffnung 15 ist am Außenumfang des Behälterkörpers 14 eine Auffangrinne 30 unterhalb der Öffnung 15 vorgesehen, um gegebenenfalls über die Öffnung 15 ausströmendes Behandlungsfluid aufzufangen, und auf geeignete, nicht näher dargestellte Weise abzuleiten.

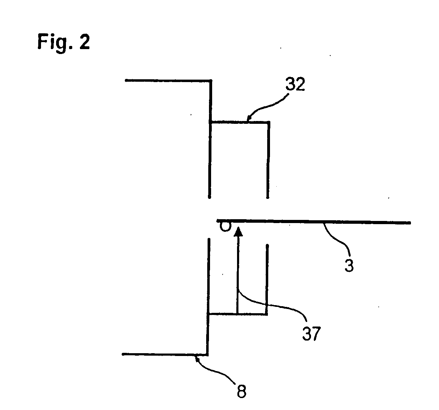

Die Ausführöffnung 16 ist von einer Trocknungskammer 32 umgeben, die am Außenumfang des Behälterkörpers 14 angebracht ist und eine integrierte Auffangrinne aufweist. Die Trocknungskammer 32 weist eine Öffnung 33 auf, durch die der Wafer 3 hindurch bewegt werden kann. Innerhalb der Trocknungskammer 33 sind Düsen 34, 35 vorgesehen, über die ein die Oberflächenspannung des Behandlungsfluids reduzierendes Fluid in den Bereich der Ausführöffnung 16 geleitet werden kann. Als Oberflächenspannung reduzierendes Fluid ist beispielsweise IPA, ein heißes Gas, wie beispielsweise heißes N₂ usw. geeignet. Das die Oberflächenspannung des Behandlungsfluids reduzierende Fluid wird über die Düsen 34, 35 gezielt auf einen zwischen dem Behandlungsfluid 20 und dem Wafer 3 gebildeten Meniskus gerichtet, um dort eine gute Trocknung gemäß dem Marangonieprinzip zu erreichen. Alternativ könnte der Meniskus auch auf andere Art, wie beispielsweise mit einem Laser erhitzt werden, um in diesem Bereich eine Verringerung der Oberflächenspannung zu erreichen. Figur 2 zeigt eine vergrößerte Detailansicht der Trocknungskammer 32, wobei die Düsen 34, 35 zur Vereinfachung der Darstellung weggelassen wurden. Wie in Figur 2 zu erkennen ist, ist in einer unteren Hälfte der Trocknungskammer 32 ein nadelförmiges Element 37 vorgesehen, welches als Tropfenfänger dient. Am hinteren Waferrand ist der Trocknungsvorgang mittels des Marangonieffekts beim Austritt aus der Kammer kritisch und es kann dazu kommen, daß feste Flüssigkeit an dem Wafer anhaftet und einen Tropfen bildet. Dieser Tropfen wird jedoch durch den Tropfenfänger, der mit einem geringen Abstand wie beispielsweise < 1 Millimeter zu dem Wafer und an dessen Wafermitte positioniert ist abgeleitet.

In der oberen Wand des Behälterkörpers 14 ist eine nicht näher dargestellte Öffnung vorgesehen, die mit einer Vakuumvorrichtung 37 in Verbindung steht, so daß in einem oberhalb des Behandlungsfluid 20 gebildeten Luftraum 40 ein Unterdruck angelegt werden kann, um ein Herausfließen des Behandlungsfluids aus dem Prozeßbehälter 8 zu verhindern. Es können auch andere Mittel an bzw. in dem Prozeßbehälter 8 vorgesehen sein, um ein Herausfließen des Behandlungsfluids zu verhindern, wie sie beispielsweise in der EP-A-0 817 246 beschrieben sind.

Die Überlauföffnung 17 ist von einem geschlossenen Überlaufbehälter 42 umgeben, der in abgedichteter Weise an dem Außenumfang des Behälterkörpers 14 befestigt ist. Innerhalb des Überlaufbehälters 42 bzw. an einer Außenwand des Prozeßbehälterkörpers 14 ist ein Schieber 44 vorgesehen, der eine Überlaufkante 45 definiert. Der Schieber 44 ist über eine nicht näher dargestellte Vorrichtung vertikal verschiebbar, um eine Höheneinstellung der Überlaufkante 45, und somit das Niveau des Behandlungsfluids 20 in dem Prozeßbehälter 8 einzustellen. Dabei wird der Einstellbereich durch die Ober- und Unterkanten der Überlauföffnung 17 beschränkt.

Obwohl in der Figur nur ein Prozeßbehälter 8 dargestellt ist, ist es möglich mehrere Prozeßbehälter hintereinander anzuordnen, so daß ein Wafer 3 auf seinem linearen Bewegungspfad durch mehrere Prozeßbehälter hindurchlaufen kann. Die jeweiligen Prozeßbehälter können mit unterschiedlichen Behandlungsfluids gefüllt sein, um unterschiedliche Behandlungsschritte, wie z.B. Ätzen, Neutralisieren und Reinigen, sowie Trocknen durchzuführen. Vorzugsweise ist zwischen jeweils aufeinanderfolgenden Prozeßbehältern 8 eine Befeuchtungseinrichtung 4 vorgesehen, um ein Antrocknen von Behandlungsfluids zwischen aufeinanderfolgenden Prozeßschritten zu verhindern. Ferner kann durch die Befeuchtung der Substrate eine grobe Vorreinigung derselben erreicht werden, so daß eine Verschleppung der Behandlungsfluids von einem Prozeßbehälter zum nächsten vermindert wird. Da die unterschiedlichen Behandlungsfluids in der Regel unterschiedliche Dichten aufweisen, wird das Niveau des Behandlungsfluids über den Schieber 44 jeweils so eingestellt, daß der Druck des Behandlungsfluids an den jeweiligen Ein- und Ausführöffnungen 15, 16 nicht dazu führt, daß das Behandlungsfluid aus dem Prozeßbehälter herausfließt. Ferner wird über die Vakuumvorrichtung 37 ein Unterdruck in dem über dem Behandlungsfluid befindlichen Luftraum erzeugt, um den an den Öffnungen 15, 16 anstehenden Behandlungsfluiddruck weiter zu reduzieren. Dabei sind vorzugsweise alle hintereinander geschalteten Prozeßbehälter 8 mit einer einzelnen Vakuumvorrichtung verbunden, welche in den jeweiligen Prozeßbehältern einen jeweils gleichmäßigen Unterdruck erzeugt oder bei gleicher Schieberhöhe unterschiedliche Unterdrücke. Durch unterschiedliche Dichten der Behandlungsfluids entstehende Druckveränderungen an den Öffnungen 15, 16 werden über den Schieber 44, und somit das Niveau des Behandlungsfluids 20 in den Prozeßbehältern ausgeglichen, so daß kein Behandlungsfluid über die Öffnungen 15, 16 aus den Prozeßbehältern 8 austritt.

Bei der Behandlung der Wafer 3 wird zunächst über die Diffusorplatte 22 Behandlungsfluid 20 in den Prozeßbehälter 8 eingeleitet bis dieses über die Überlaufkante 45 des Schiebers 44 in den Überlaufbehälter 42 fließt. Über die Diffusorplatte 22 wird ständig Behandlungsfluid in den Prozeßbehälter 8 eingeleitet, so daß eine homogene nach oben gerichtete Strömung innerhalb des Prozeßbehälters entsteht. Anschließend wird über die Einführöffnung 15 ein Wafer 3 in den Prozeßbehälter 8 hinein und teilweise dort hindurch geschoben. Dabei werden die Vorder- und Rückseiten des Wafers 3 mittels der Ultraschalleinrichtungen 24, 26 beschallt. Innerhalb des Prozeßbehälters 8 werden die Wafer 3 durch die seitlichen Führungen 18 geführt. Wenn ein vorderes Ende des Wafers 3 durch den Prozeßbehälter 8 hindurch geführt ist, wird der dabei entstehende Meniskus zwischen Behandlungsfluid 20 und Wafer 3 mit einem die Oberflächenspannung des Behandlungsfluids 20 reduzierenden Fluids beaufschlagt, wodurch der Wafer 3 bei der Entnahme aus dem Behandlungsfluid 20 getrocknet wird. Das Führungsende des Wafers 3 wird durch die Transporteinheit 10 aufgenommen und vollständig durch den Prozeßbehälter 8 hindurch gezogen und gegebenenfalls zu einem nachfolgenden Prozeßbehälter 8 transportiert.

Obwohl die Erfindung anhand eines bevorzugten Ausführungsbeispiels beschrieben wurde, sei bemerkt, daß die Erfindung nicht auf dieses Ausführungsbeispiel beschränkt ist. Beispielsweise sind die Merkmale der Trocknungskammer 32 bei Prozeßbehältern 8 nicht notwendig, denen ein weiterer Prozeßbehälter nachgeschaltet ist. Ferner ist die genaue Ausgestaltung der Ultraschalleinrichtung nicht zwingend, da abhängig von dem zu behandelndem Substrat beispielsweise eine einzelne Ultraschalleinrichtung zur Behandlung einer Substratoberfläche ausreicht. Auch ist eine Diffusorplatte 22 nicht zwingend notwendig und es könnte statt dessen oder in Kombination mit der Diffusorplatte ein trichterförmiger Boden mit einer Einlaßöffnung vorgesehen werden. Auch ist die Vakuumvorrichtung 37 nicht unbedingt notwendig, da der an den Öffnungen 15, 16 anstehende Druck auch über andere Mittel, wie beispielsweise eine Kapillarvorrichtung, geregelt werden kann. Der dabei erforderliche Druck wird über den beweglichen Schieber 44 geregelt. Die jeweiligen Merkmale der Behandlungsvorrichtung 1 können in Kombination oder jeweils auch einzeln, d.h. unabhängig voneinander eingesetzt werden.

## Patentansprüche

1. Vorrichtung (1) zum Behandeln von Substraten (3) mit wenigstens einem in einer Gasatmosphäre angeordneten, eine Behandlungsflüssigkeit (20) enthaltenden Prozeßbehälter (8),
der wenigstens zwei Öffnungen (15,16) unterhalb der Flüssigkeitsoberfläche zum linearen Durchführen der Substrate (3) aufweist, die so ausgeformt sind, daß sie ein Ausfließen der im Prozeßbehälter (8) befindlichen Behandlungsflüssigkeit (20) unterbinden, und
der einen Einlaß (22) für die Behandlurigsflüssigkeit unterhalb der Öffnungen (15,16) und eine Überlauf (17,42,44) für die Behandlungsflüssigkeit oberhalb der Öffnungen (15,16) aufweist,
**dadurch gekennzeichnet, dass** der Prozeßbehälter (8) durch einen Behälterkörper (14) mit den Öffnungen (15,16), den Einlaß (22) und einer Überlauföffnung (17) gebildet wird, wobei
die Überlauföffnung mit einem geschlossenen Überlaufbehälter (42), der in abgedichteter Weise am Außenumfang des Behälterkörpers (14) befestigt ist, umgeben ist,
die Überlauföffnung mit Überlaufbehälter den Überlauf bilden und zusammen mit dem Behälterkörper (14) einen geschlossenen Raum (40) oberhalb der Behandlungsflüssigkeitsoberfläche bilden, und
eine Einrichtung (37) zum Erzeugen eines Unterdruckes im geschlossenen Raum (40) vorgesehen ist.

2. Vorrichtung nach Anspruch 1, **dadurch gekennzeichnet, daß** der Überlauf höhenverstellbar ist.

3. Vorrichtung nach einem der vorhergehenden Ansprüche, **gekennzeichnet durch** eine im wesentlichen horizontal angeordneten Diffusorplatte (22) im Prozeßbehälter (8).

4. Vorrichtung nach einem der vorhergehenden Ansprüche, **gekennzeichnet durch** einen unterhalb wenigstens einer Öffnung (15, 16) angebrachten Auffangrinne (30) am Außenumfang des Prozeßbehälters (8).

5. Vorrichtung nach Anspruch 4, **gekennzeichnet durch** einen Tropfenfänger in der Auffangrinne.

6. Vorrichtung nach einem der vorhergehenden Ansprüche, **gekennzeichnet durch** wenigstens eine Ultraschalleinrichtung (24, 26) innerhalb des Prozeßbehälters (8).

7. Vorrichtung nach Anspruch 6, **dadurch gekennzeichnet, daß** die Ultraschalleinrichtung (24, 26) über die gesamte Breite des Prozeßbehälters (8), senkrecht zur Bewegungsrichtung der Substrate von einer der zwei Öffnungen (15, 16) zur andern der zwei Öffnungen (15, 16) erstreckt.

8. Vorrichtung nach Anspruch 6 oder 7, **dadurch gekennzeichnet, daß** die Ultraschalleinrichtung (24, 26) auf der vom Substrat wegweisende Seite abgeschrägt ist, um eine für eine von unten nach oben im Prozeßbehälter gerichtete Flüssigkeitsströmung strömungsdynamische Form zu bilden.

9. Vorrichtung nach einem der Ansprüche 6 bis 8, **dadurch gekennzeichnet, daß** wenigstens zwei zueinander weisenden Ultraschalleinrichtungen (24, 26) vorgesehen sind, wobei jeweils wenigstens eine der Ültraschalleinrichtungen höhenmäßig oberhalb bzw. unterhalb der Öffnungen liegt, sodaß das Substrat (3) dazwischen hindurch bewegbar ist.

10. Vorrichtung nach einem der vorhergehenden Ansprüche, **gekennzeichnet durch** eine die Öffnung (16), die eine Ausgangsöffnung für die Substrate darstellt, umgebende Trocknungskammer (32) mit einer Einrichtung (34, 35) zum Einleiten eines die Oberflächenspannung der Behandlungsflüssigkeit (20) verringernden Fluids.

11. Vorrichtung nach einem der vorhergehenden Ansprüche, **gekennzeichnet durch** mehrere hintereinander angeordnete Prozeßbehälter (8).

12. Vorrichtung nach Anspruch 11, **gekennzeichnet durch** Einrichtungen zum Einleiten unterschiedlicher Behandlungsflüssigkeiten (20) in die jeweiligen Prozeßbehälter (8).

13. Vorrichtung nach einem der Ansprüche 10 bis 12, **gekennzeichnet durch** eine Befeuchtungseinrichtung (4) zwischen den Prozeßbehältern (8).

## Claims

1. Device (1) for the treatment of substrates (3) with at least one processing container (8) arranged in a gaseous atmosphere, containing a treatment fluid (20),
containing at least two openings (15, 16) below the fluid surface for the linear passing through of the substrates (3), which are shaped in such a manner that they prevent the flowing out of any treatment fluid (20) present in the processing container (8), and
having an inlet (22) for the treatment fluid below the openings (15, 16), and an overflow (17, 42, 44) for the treatment fluid above the openings (15, 16),
**characterized in that** the processing container (8) is embodied by a container body (14) with the openings (15, 16), the inlet (22), and an overflow opening (17), wherein
the overflow opening is surrounded by a closed overflow container (42), which is attached to the outer circumference of the container body (14) in a sealed manner,
the overflow opening and the overflow container form the overflow, and together with the container body (14) form a closed space (40) above the treatment fluid surface, and
a unit (37) for creating a low pressure within the closed space (40) is provided.

2. Device according to claim 1, **characterized in that** the overflow is vertically adjustable.

3. Device according to one of the previous claims, **characterized by** an essentially horizontally arranged diffuser plate (22) within the processing container (8).

4. Device according to one of the previous claims, **characterized by** a collecting channel (30) at the outer circumference of the processing container (8) below at least one opening (15, 16).

5. Device according to claim 4, **characterized by** a drip catcher in the collecting channel.

6. Device according to one of the previous claims, **characterized by** at least one ultrasound unit (24, 26) within the processing container (8).

7. Device according to claim 6, **characterized in that** the ultrasound unit (24, 26) extends perpendicular to the direction of movement of the substrates from one of the two openings (15, 16) towards the other of the two openings (15, 16) across the entire width of the processing container (8).

8. Device according to claims 6 or 7, **characterized in that** the ultrasound unit (24, 26) is chamfered at the side facing away from the substrate in order to form a fluid-dynamic shape for a fluid flow within the processing container that is directed from the bottom upwards.

9. Device according to one of the claims 6 to 8, **characterized in that** at least two ultrasound units (24, 26) facing each other are provided, wherein at least one of the ultrasound units is respectively positioned above or below the openings with regard to its height so that the substrate (3) can be moved through the same.

10. Device according to one of the previous claims, **characterized by** a drying chamber (32) surrounding the opening (16), which represents an outlet opening for the substrates, with a unit (34, 35) for feeding of a fluid reducing the surface tension of the treatment fluid (20).

11. Device according to one of the previous claims, **characterized by** several successively arranged processing containers (8).

12. Device according to claim 11, **characterized by** units for the feeding of different treatment fluids (20) into the respective processing containers (8).

13. Device according to one of the claims 10 to 12, **characterized by** a wetting unit (4) between the processing containers (8).

## Revendications

1. Dispositif (1) pour le traitement de substrats (3), comportant au moins un récipient de service (8), disposé dans une atmosphère gazeuse, contenant un liquide de traitement (20),
qui comporte au moins deux ouvertures (15, 16), en dessous de la surface du liquide pour le passage linéaire des substrats (3), qui sont formées de telle sorte qu'elles empêchent un écoulement vers l'extérieur du liquide de traitement (20) contenu dans le récipient de service (8), et
qui comporte une admission (22) pour le liquide de traitement en dessous des ouvertures (15, 16)-, et un trop-plein (17, 42, 44) pour le liquide de traitement au-dessus des ouvertures (15, 16),
**caractérisé en ce que** le récipient de service (8) est formé par un corps de récipient (14) avec les ouvertures (15, 16), l'admission (22) et une ouverture de trop-plein (17), dans lequel
l'ouverture de trop-plein est entourée par un récipient de trop-plein (42) fermé, qui est fixé de manière étanche à la circonférence extérieure du corps de récipient (14),
l'ouverture de trop-plein avec le récipient de trop-plein forment le trop-plein et conjointement avec le corps de récipient (14) forment un compartiment (40) fermé au-dessus de la surface du liquide de traitement, et
il est prévu un dispositif (37) destiné à générer une dépression dans le compartiment (40) fermé.

2. Dispositif selon la revendication 1, **caractérisé en ce que** le trop-plein est réglable en hauteur.

3. Dispositif selon l'une quelconque des revendications précédentes, **caractérisé par** une plaque de diffusion (22) agencée essentiellement horizontalement dans le récipient de service (8).

4. Dispositif selon l'une quelconque des revendications précédentes, **caractérisé par** une goulotte collectrice (30), montée en dessous d'au moins une ouverture (15, 16) sur la circonférence extérieure du récipient de service (8).

5. Dispositif selon la revendication 4, **caractérisé par** un collecteur de gouttes dans la goulotte collectrice (30).

6. Dispositif selon l'une quelconque des revendications précédentes, **caractérisé par** au moins un dispositif à ultrasons (24, 26) à l'intérieur du récipient de service (8).

7. Dispositif selon la revendication 6, **caractérisé en ce que** le dispositif à ultrasons (24, 26) s'étend sur toute la largeur du récipient de service (8), perpendiculairement à la direction de déplacement des substrats, depuis l'une des deux ouvertures (15, 16) vers l'autre des deux ouvertures (15, 16).

8. Dispositif selon la revendication 6 ou 7, **caractérisé en ce que** le dispositif à ultrasons (24, 26) est chanfreiné sur le côté détourné du substrat, afin d'obtenir une forme d'écoulement dynamique pour un flux de liquide dirigé du bas vers le haut dans le récipient de service (8).

9. Dispositif selon l'une quelconque des revendications 6 à 8, **caractérisé en ce qu'**il est prévu au moins deux dispositifs à ultrasons (24, 26) orientés l'un vers l'autre, dans lequel au moins l'un des dispositifs à ultrasons est situé en hauteur respectivement au-dessus ou au-dessous des ouvertures, de telle sorte que le substrat (3) peut se déplacer entre celles-ci.

10. Dispositif selon l'une quelconque des revendications précédentes, **caractérisé par** une chambre de séchage (32), qui entoure l'ouverture (16), qui constitue une ouverture de sortie pour les substrats, avec un dispositif (34, 35) pour l'admission d'un liquide diminuant la tension superficielle du liquide de traitement (20).

11. Dispositif selon l'une quelconque des revendications précédentes, **caractérisé par** plusieurs récipients de service (8) montés les uns derrière les autres.

12. Dispositif selon la revendication 11, **caractérisé par** des dispositifs destinés à l'admission de différents liquides de traitement (20) dans les récipients de service (8) respectifs.

13. Dispositif selon l'une quelconque des revendications 10 à 12, **caractérisé par** un dispositif d'humidification (4) entre les récipients de service (8).
